(19) **Europäisches Patentamt / European Patent Office / Office européen des brevets**

(11) **EP 1 626 495 B1**

(12) **EUROPEAN PATENT SPECIFICATION**

(45) Date of publication and mention
of the grant of the patent:
**16.01.2008 Bulletin 2008/03**

(21) Application number: **04734421.3**

(22) Date of filing: **21.05.2004**

(51) Int Cl.:
***H03D 3/02*** *(2006.01)*      ***G01N 13/10*** *(2006.01)*

(86) International application number:
**PCT/JP2004/007319**

(87) International publication number:
**WO 2004/105230 (02.12.2004 Gazette 2004/49)**

(54) **FM SIGNAL DEMODULATION METHOD AND DEVICE THEREOF**

VERFAHREN UND VORRICHTUNG ZUR DEMODULIERUNG VON UKW-SIGNALEN

PROCEDE DE DEMODULATION DE SIGNAL FM ET DISPOSITIF DE REALISATION DE CE PROCEDE

(84) Designated Contracting States:
**CH DE FR GB LI**

(30) Priority: **22.05.2003   JP 2003144728**
          **22.05.2003   JP 2003144729**

(43) Date of publication of application:
**15.02.2006   Bulletin 2006/07**

(73) Proprietor: **Japan Science and Technology Agency**
**Kawaguchi-shi,**
**Saitama 332-0012 (JP)**

(72) Inventors:
• **KOBAYASHI, Dai**
  **Setagaya-ku,**
  **Tokyo 157-0061 (JP)**

• **KAWAKATSU, Hideki**
  **Setagaya-ku, Tokyo 158-0086 (JP)**

(74) Representative: **Hoarton, Lloyd Douglas Charles**
**Forrester & Boehmert**
**Pettenkoferstrasse 20-22**
**80336 München (DE)**

(56) References cited:
**EP-A- 0 623 993**          **JP-A- 6 069 967**
**JP-A- 6 077 737**          **JP-A- 2001 116 679**
**US-A- 4 755 761**

• **"high speed direct conversion fm demodulator" IBM TECHNICAL DISCLOSURE BULLETIN, vol. 35, no. 4b, 1 September 1992 (1992-09-01), pages 344-345, XP002373701 new york**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**Description**

Technical Field

The present invention relates to an FM signal demodulating method and a device thereof.

Background Art

Conventionally, the following FM signal demodulating methods or devices exist.

    (1) Slope detector and double-tuned detector
    (2) Quadrature detector
    (3) Delay detector
    (4) Ratio detector
    (5) PLL detector

Hereinbelow, a description is given of the FM signal demodulating methods.

(1) slope detector and double-tuned detector

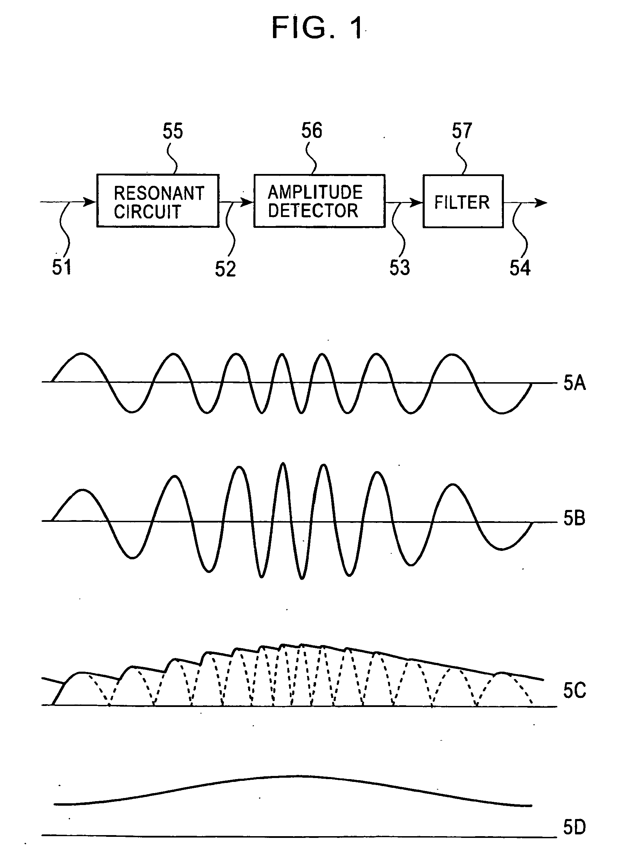

Fig. 1 is a block diagram showing conventional slope detector and waveform charts of units in the block.
Referring to Fig. 1, an input signal 51 is FM-modulated (waveform 5A). Therefore, the property between the frequency and the amplitude of a resonant circuit 55 enables the input signal 51 to a signal 52 subjected to amplitude modulation (waveform 5B). The signal 52 is subjected to amplitude detection 56 (waveform 5C), thereby generating a signal 53. A filter 57 extracts a low-frequency component 54 (waveform 5D), thereby demodulating an FM signal.

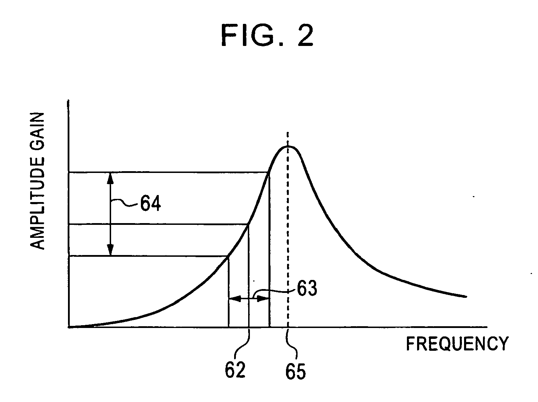

Fig. 2 is a diagram showing one example of the frequency-amplitude characteristic of the resonant circuit used for the conventional slope detector. Referring to Fig. 2, the abscissa denotes the frequency and the ordinate denotes the amplitude gain.
The resonant circuit is tuned to a frequency 65 being slightly apart from the central frequency 62 of the FM signal, and by using a portion having the large inclination of the frequency-amplitude characteristic, the sensitivity in converting a frequency shift 63 to amplitude change 64 is improved.
According to the FM signal demodulating method of the conventional double-tuned detector using the above-mentioned two resonant circuits, the resonant frequency of one of the two resonant circuits is tuned to a frequency larger than the central frequency of the FM signal, the resonant frequency of the other resonant circuit is tuned to a frequency smaller than the central frequency of the FM signal, and results of the slope detectors are combined, thereby improving the linearity.

(2) Quadrature detector

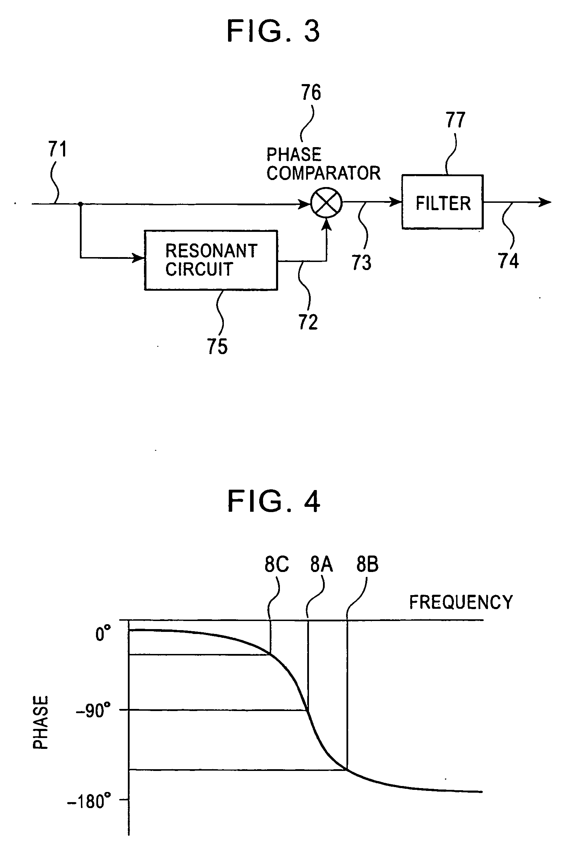

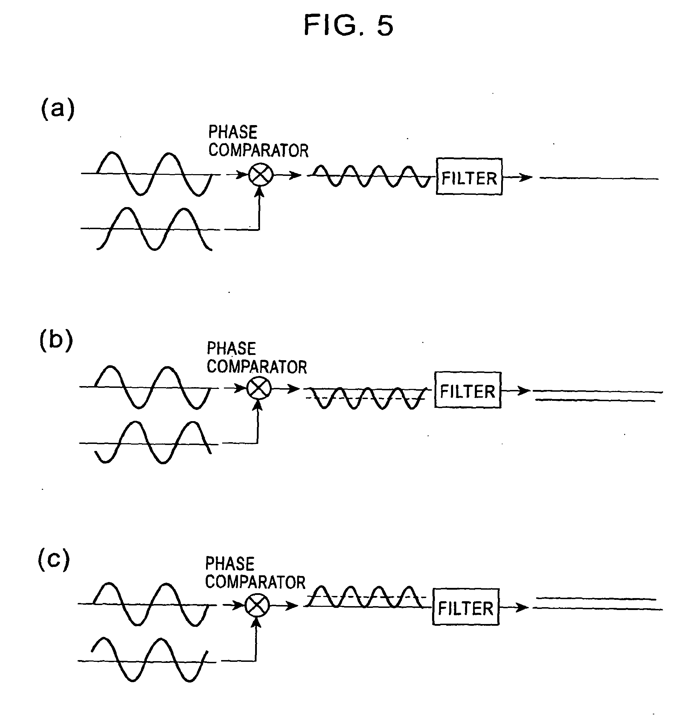

Fig. 3 is a block diagram showing conventional quadrature detector.
Referring to Fig. 3, an input signal 71 is directly inputted to a phase comparator 76, and a signal 72 which passes through a resonant circuit 75 for phase change is inputted to the phase comparator 76. A low-frequency component 74 is extracted, via a filter 77, from an output 73 of the phase comparator 76, thereby demodulating the FM signal.
Fig. 4 is a diagram showing an example of the phase change between the input and the output, caused by the resonant circuit in the conventional quadrature detector. Referring to Fig. 4, the abscissa denotes the frequency, and the ordinate denotes the phase.
At a central frequency 8A of an input signal, the resonant circuit is tuned so that the phase is delayed by 90 degrees. Thus, the phase is delayed at an angle of over 90 degrees with the positive frequency shift of the input signal (8B), and the phase is delayed at an angle of not less than 90 degrees with the negative frequency shift of the input signal (8C). For the same purpose of the resonant circuit, a ceramic oscillator can be used.
Though an exclusive OR gate can be used as the phase comparator as well as an analog multiplier, here, a description of the operation is given using an analog multiplier with reference to Fig. 5.
Fig. 5 is an explanatory diagram of the operation of a phase comparator using an analog multiplier.
When the phases of a pair of signals inputted to the analog multiplier are orthogonal as shown in [Fig. 5(a)], the multiplying result does not include the DC component. When the pair of signals has the difference in phase over 90 degrees or less than 90 degrees as shown in [Figs. 5(b) and 5(c)], the multiplying result includes the DC component which reflects the phase difference.

### (3) Delay detector

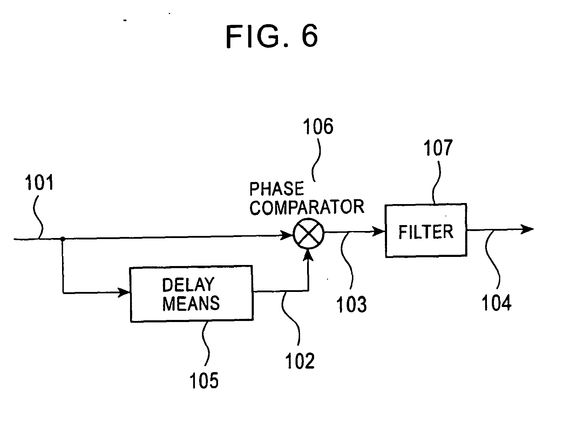

Fig. 6 is a typical block diagram showing conventional delay detector.

In the delay detector, the resonant circuit for quadrature detector is replaced with time delay means, and the delay detector can be classified into the quadrature detector in wider sense. An input signal 101 is directly inputted to a phase comparator 106, and a signal 102 which is delayed via delay means 105 is inputted to a phase comparator 106. A low-frequency component 104 is extracted, via a filter 107, from an output 103 of the phase comparator 106, thereby demodulating the FM signal.

The delay means 105 is arranged to delay the signal at a constant time, irrespective of the signal frequency. As a result of the constant-time delay, the frequency component included in the signal 102 is delayed with the phase proportional to the frequency. When the delay detector is realized by an analog circuit, a coaxial cable or a delay line is used as the delay means. When the delay detector is realized as digital signal processing, sampling data at the past time point is used as the delayed signal.

The following non-patent document 1 describes a method for the delay detector as the digital signal processing.

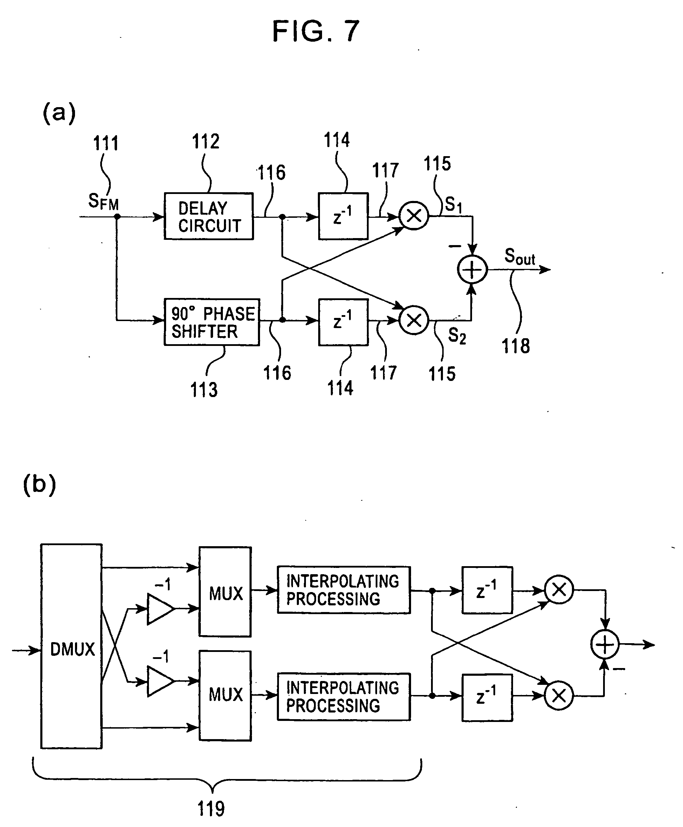

Fig. 7 is a diagram showing a method without using a filter for extracting the low-frequency component.

Referring to Fig. 7(a), an FM signal 111 is inputted to a delay circuit 112 and is inputted to a 90 degrees phase shifter 113. Then, outputs 116 of the delay circuit 112 and a 90 degrees phase shifter 113 are delayed at one-sampling time period by circuit components 114, thereby obtaining signals 117. The outputs 116 and the signals 117 are multiplied across each other, thereby obtaining results 115. The results 115 are subtracted from each other, thereby obtaining an output 118.

The 90 degrees phase shifter 113 changes the phase of 90 degrees throughout the entire frequency shift range of the FM signal, irrespective of the frequency. The delay circuit 112 compensates for the time delay caused by the 90 degrees phase shifter 113. Thus, the phases of the pair of signals 116 shift from each other by 90 degrees. Thereafter, the signals 115 obtained by multiplying the delayed signals 117 to the original signals 116 have high-frequency components of the same phase and low-frequency components of the opposite phase. Therefore, only the low-frequency component is extracted by the mutual subtraction. In the example shown in Fig. 7(b), only a former-half processing unit 119 is different and the subsequent processing is the same as that shown in Fig. 7(a).

### (4) Ratio detector

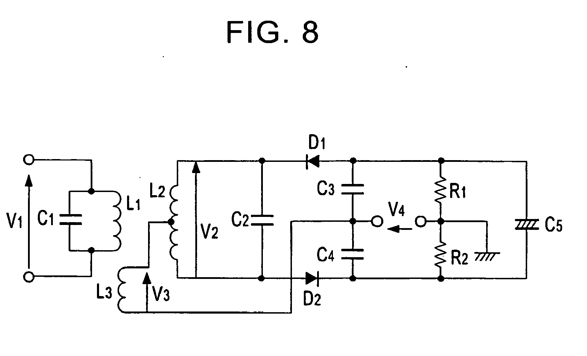

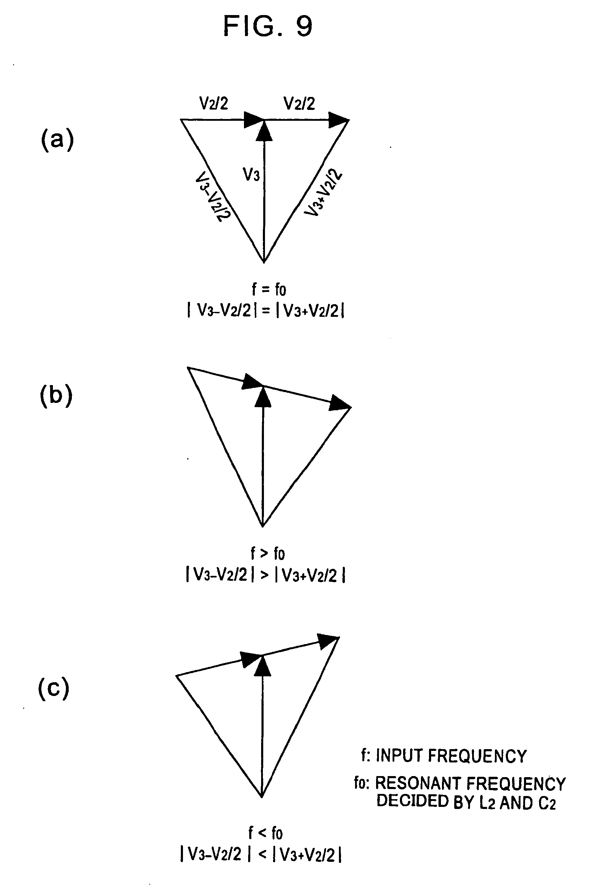

Fig. 8 is a circuit diagram of conventional ratio detector. Fig. 9 is a vector diagram of a conventional ratio detecting circuit.

A parallel resonant circuit comprising a coil $L_2$ and a capacitor $C_2$ shown in Fig. 8 is tuned to the central frequency of the FM signal. A voltage $V_3$ and a voltage $V_2$ are generated from an FM signal $V_1$ by the mutual induction of a coil $L_1$ and a coil $L_3$ and the coil $L_1$ and a coil $L_2$. A phase of the voltage $V_2$ is orthogonal to a phase of the voltage $V_3$ at the central frequency of the FM signal. The frequency of the FM signal shifts from the central frequency and, then, the phase of the voltage $V_2$ to the voltage $V_3$ changes by the characteristics of parallel resonance comprising the coil $L_2$ and the capacitor $C_2$.

A signal obtained by adding the half of the voltage $V_2$ and the voltage $V_3$ in vector and a signal obtained by subtracting the half of the voltage $V_2$ from the voltage $V_3$ in vector are applied to an amplitude detecting circuit comprising a diode $D_1$ and a capacitor $C_3$ and an amplitude detecting circuit comprising a diode $D_2$ and a capacitor $C_4$.

Referring to Fig. 9, when a frequency f of the FM signal matches the central frequency $f_0$, the vector addition of the half of the voltage $V_2$ and the voltage $V_3$ has the same amplitude as that of the vector subtraction thereof as shown in [Fig. 9(a)]. However, when the frequency shifts, the phase of the voltage $V_2$ changes. Thus, there is the difference between the vector addition of the half of the voltage $V_2$ and the voltage $V_3$ and the vector subtraction of the half of the voltage $V_2$ from the voltage $V_3$ as shown in [Figs. 9(b) and 9(c)]. The ratio detecting circuit outputs a difference $V_4$ between the amplitude detecting circuits, thereby demodulating the FM signal.

### (5) PLL detector

In PLL (Phase-Locked Loop) detector, a voltage controlled oscillator is used, as voltage/frequency converting means, to change an output frequency by an input voltage, without direct conversion between the frequency and the voltage. Then, the voltage controlled oscillator is inserted into a negative-feedback loop, thereby realizing the conversion between the frequency and the voltage (FM-signal demodulation).

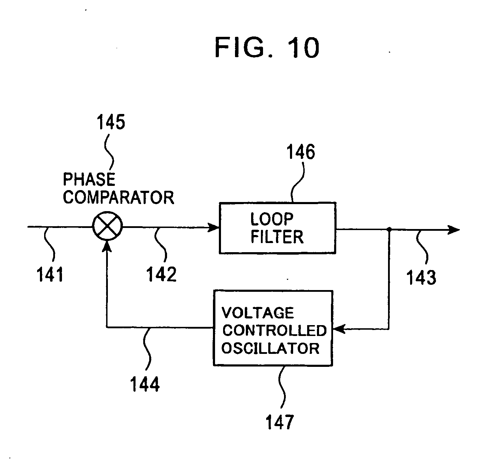

Fig. 10 is a block diagram showing conventional PLL detector. An FM signal 141 and an output signal 144 of a voltage controlled oscillator 147 are inputted to a phase comparator 145. The phase comparator 145 comprises an analog multiplier, an exclusive OR gate or flip-flop, and outputs a voltage 142 indicating the phase difference between a signal 141 and a signal 144. The output 142 of the phase comparator 145 is inputted to the voltage control oscillator 147 via a loop filter 146 so as to stabilize the system, the negative feedback is thus established, and the phase difference between the signal 144 and the FM signal 141 is locked to be constant. Incidentally, reference numeral 143 denotes an output signal.

Since the frequency denotes the time differentiation of phases, the control operation for keeping the phase difference to be constant means the control operation for preventing the frequency difference (the frequencies are equal). Therefore, since a control voltage of the voltage controlled oscillator changes reflecting the frequency shift of the input frequency, demodulation of the FM signal is achieved.

[Non-Patent Document 1]

"Information Communication and Digital Signal Processing (Joho Tsushin to digital signal shori" of Digital-Signal-Processing Library 8, in pages 153-154, edited and written by Takashi TANIHAGI, published by CORONA

[Non-Patent Document 2]

IRE Transactions on Circuit Theory, June 1960, Pages 128-136, Normalized Design of 90 degrees Phase-Difference Networks, S. D. Bedrosian

A document entitled "High Speed Direct Conversion FM demodulator", published in IBM Technical Disclosure Bulletin, Volume 35, No. 4B, 1 September 1920 (1920-09-01), Pages 344-345, XP002373701 New York, discloses a demodulating technique for FM signals.

The present invention seeks to provide an improved FM signal demodulating device.

According to the present invention, there is provided an FM signal demodulating device as defined in claim 1 hereinafter.

However, in the above-mentioned conventional slope detector, double-tuned detector, quadrature detector, and ratio detector, the resonant circuit is forcedly oscillated by the frequency of the FM signal and the frequency shift is detected by the amplitude property or phase property of the resonant circuit. The improvement of detecting sensitivity thus needs the increase in Q value of the resonant circuit. Further, a crystal oscillator needs to be used, in place of the resonant circuit, so as to stabilize the drift of the central frequency to 1 ppm or less. However, the Q value of the crystal oscillator is higher, e.g., several thousands or more.

In the slope detector, when the Q value of the resonant circuit is increased, the amplitude change of the resonant circuit is delayed. Further, in the quadrature detector and ratio detector, when the Q value of the resonant circuit is increased, oscillatory transient phenomenon in phase is then indicated. Therefore, in the slope detector, quadrature detector, and ratio detector, it is impossible in principle to establish both the high sensitivity and the high response-speed, or both the high stability of central frequency and the high response-speed. For example, an FM demodulator for an FM signal having 10MHz central frequency can not establish the FM demodulation of the modulation frequency reaching to 100 kHz while simultaneously establishing the stability of the central frequency within 1 Hz within a temperature range from 0°C to 40°C.

In the delay detector, the relationship between the frequency and the phase of the delay circuit is linear, passing through the origin, the phase does not sharply change near a specific frequency like the above-mentioned resonant circuit, the linearity is therefore high, however, the sensitivity is generally low, and the delay with stability of ppm order is not easily realized. Normally, the delay time is 1/4 of the period of the FM signal or less. As the delay time is longer, the sensitivity is increased without limit in principle. However, the demand for stability of delay time is simultaneously strict.

The performance of PLL method is determined depending on the performance of the conversion performance between the voltage and the frequency of the voltage controlled oscillator. A voltage controlled crystal oscillator (VCXO) obtained by combining a crystal oscillator and a voltage variable reactance element is used, thereby realizing the stability of 1 ppm or less and improving the sensitivity. Further, since the oscillator uses the resonant phenomenon as self-excitation oscillation, the response speed is not slow even if the Q value is high. However, the linearity deteriorates in the voltage/frequency performance of VCXO, and the frequency variable range is limited to 100 ppm. Further, since the negative feedback loop is provided, the phase lock is reset in the case of sharp change in frequency.

Embodiments of the present invention seek to solve the following problems which cannot be solved by the above-mentioned conventional FM signal demodulating methods.

(1) Factors for determining the sensitivity, response speed, and stability, which are essentially independent, are based on the FM signal demodulating method.
(2) Essentially, the FM signal demodulating method has a linear relationship between the frequency and the output value.
(3) The FM signal demodulating method does not have a feedback loop.

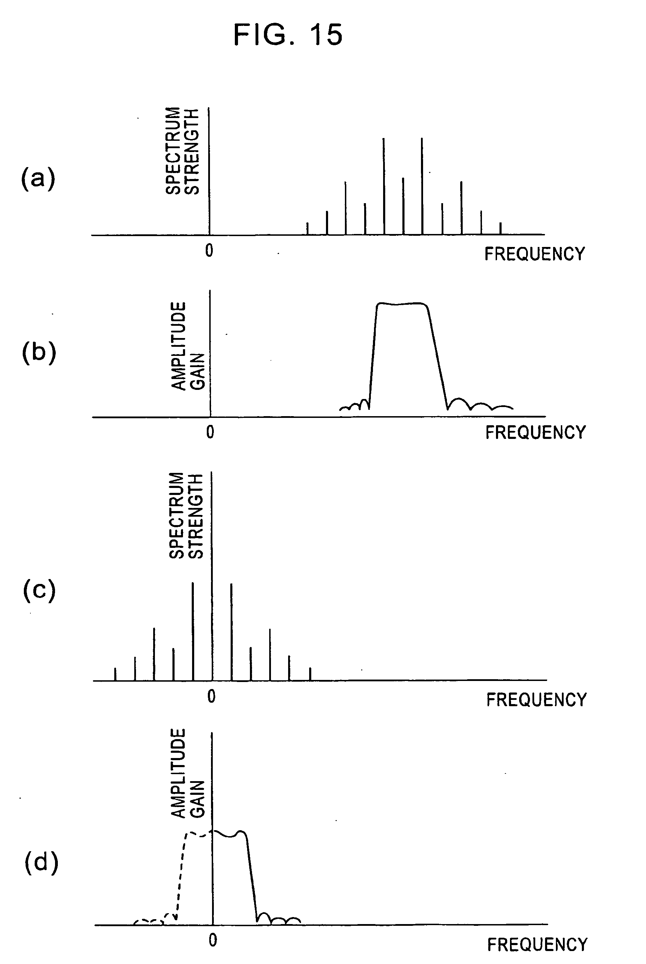

Further, when the band limit is to be provided for sidewaves of the FM signal as shown in [Fig. 15(a)], all the conventional FM signal demodulating methods use intermediate frequencies except for 0 Hz. Therefore, a band limiting filter becomes a band pass filter as shown in [Fig. 15(b)]. The frequency property of the band pass filter cannot be completely symmetric to the central frequency in linear-scale view. Further, the frequency property of the band pass filter cannot be changed while keeping the synmetricity.

In consideration of the above-mentioned situation, embodiments of the present invention provide an FM signal demodulating method and a device thereof, in which the sensitivity of an FM signal demodulator is easily changed and the differentiation without waveform distortion is used without changing the response speed due to the sensitivity change.

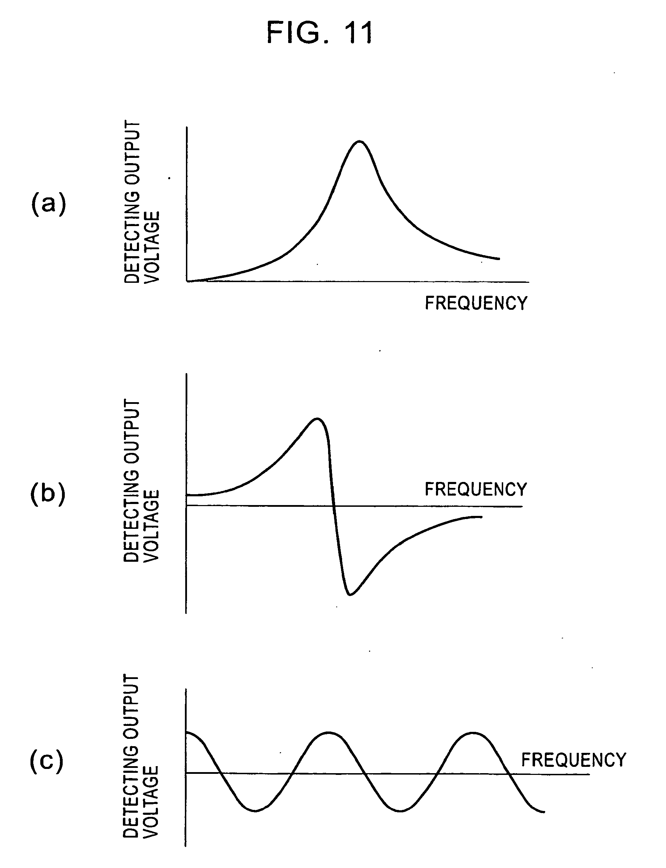

Further, according to the above-mentioned many conventional detecting methods, the outputs do not have monotonic functions of the frequency throughout a wide range. That is, in the slope detector, the frequency shift of the FM signal is increased to be over a tuning frequency 65 of the resonant circuit, then, both the frequency and the amplitude are reduced again, the detecting output does not have the monotonic function to the frequency, and the frequency property of the detecting output is the same as the property between the amplitude and the frequency of the resonant circuit as shown in Fig. 11(a). In the double-tuned detector, these properties are combined in the up and down directions as shown in Fig. 11(b).

Further, the quadrature detector and the ratio detector use the phase property of the resonant circuit, the resonant circuit has the amplitude which is reduced as it is far from the resonant frequency. When the frequency shift is small, the phase change is dominant. However, when the frequency shift is large, the reduction in amplitude is dominant and the frequency property of the detecting output is also as shown in Fig. 11(b).

In the delay detector, the frequency property of the output voltage is a periodic function of frequency as shown in [Fig. 11(c)] in which the reciprocal of the delay time corresponds to one period.

Further, in the PLL detector, the phase lock is not kept to the input frequency out of the frequency variable range of the voltage control oscillator. A phase comparator, as one type of a frequency/phase comparator, can determine whether the frequency is excessively high or excessively low when the lock is reset. However, the loop gain of the feedback loop varies depending on whether phase-lock is established or not. Therefore, a hunching phenomenon is caused in the return to the normal operation.

As mentioned above, the conventional FM signal demodulating method has a problem that an abnormal value is outputted to the frequency shift which is greatly over the demodulating target range.

The problem becomes an inconvenience when the FM signal demodulator is used in an arbitrary control loop. For example, in the case of using the FM signal demodulator so as to detect the change in resonant frequency of a cantilever of an atomic force microscopy, the problem can be a serious defect. That is, a controller of a non-contact atomic force microscopy oscillates a minute cantilever at its resonant frequency and thus the cantilever is brought close to the sample surface. The change in resonant frequency due to the atomic interaction between a tip mounted near the free end of the cantilever and the sample surface is detected and the controller controls the position of the cantilever to keep the resonant frequency to be constant. In the case of using the FM signal demodulator having the above-mentioned problem for the purpose, if the frequency shift out of a generally-prescribed range is inputted, the gain of the position control loop of the cantilever is inverted. If the inversion of the gain occurs, the cantilever is pushed against the sample when the cantilever must be separated from the sample. Under such situation, there is a danger that the cantilever or the sample might be damaged.

In consideration of the above-mentioned situation, embodiments of the present invention provide an FM signal demodulating method and a device thereof using a wideband 90 degrees phase shifter with the property for smoothly saturating the output relative to the frequency shift greatly out of the demodulating target range.

[1] According to an FM signal demodulating method using differentiation, reference signals with phases different from each other by 90 degrees and having frequencies equal to the central frequency of an FM signal to be demodulated, are frequency-mixed to the FM signal inputted, and are converted into intermediate-frequency signals I and Q having phases different from each other by 90 degrees and whose central frequencies are 0 Hz. Further, the intermediate-frequency signals I and Q are multiplied by the each other's time derivatives dQ and dI, and a difference between the multiplied signals I•dQ and Q•dI, i.e., I•dQ-Q•dI is outputted.

[2] According to an FM signal demodulating method using the differentiation described above in [1], filters for modifying the frequency components of the intermediate-frequency signals I and Q are arranged, and

[3] According to an FM signal demodulating device for detecting the shift of an oscillating frequency of a probe of a scan-type probe microscopy, the FM signal demodulating method using the differentiation described above in [1] or [2] is used.

[4] According to an FM signal demodulating method using a wideband 90 degrees phase shifter, reference signals with phases different from each other by 90 degrees and having frequencies at the central frequency of an FM signal to be demodulated, are frequency-mixed to the FM signal inputted, and are converted into intermediate-frequency signals I and Q having phases different from each other by 90 degrees and whose central frequencies are 0 Hz.

Further, the intermediate-frequency signals I and Q are phase-operated by a wideband 90 degrees phase shifter, thereby generating four signals IS, IC, QS, and QC. Calculation of the four signals, as IS•QC-IC•QS is outputted, and
[5] According to an FM signal demodulating device for detecting the shift of an oscillating frequency of a probe of a scanning probe microscopy, an FM signal demodulating method using the wideband 90 degrees phase shifter described above in [4] is used.

Brief Description of the Drawings

Fig. 1 is a block diagram showing conventional slope detector and waveform charts of units;
Fig. 2 is a diagram showing one example of the property between the frequency and the amplitude of a resonant circuit used for the conventional slope detector;
Fig. 3 is a block diagram of conventional quadrature detector;
Fig. 4 is a diagram showing one example of the phase change between the input and the output of a resonant circuit used in the conventional quadrature detector;
Fig. 5 is an explanatory diagram of the operation of a phase comparator using an analog multiplier;
Fig. 6 is a typical block diagram of conventional delay detector;
Fig. 7 is a diagram showing one example of delay detector in conventional digital signal processing;
Fig. 8 is a circuit diagram of conventional ratio detector;
Fig. 9 is a vector diagram of voltages in a conventional ratio detecting circuit;
Fig. 10 is a block diagram showing conventional PLL detector;
Fig. 11 is a diagram showing the property between an output value and a frequency according to a conventional FM signal demodulating method;
Fig. 12 is a diagram showing an FM signal demodulating method;
Fig. 13 is a diagram showing the FM signal demodulating method realized by an analog circuit;
Fig. 14 is a diagram showing waveforms in an FM signal demodulating circuit according to the FM signal demodulating method shown in Fig. 13;
Fig. 15 is a diagram showing an example of the property of sideband waves of the FM signal and a sideband wave modifying filter according to embodiments of the present invention;
Fig. 16 is a block diagram showing an FM signal demodulating method according to an embodiment of the present invention;
Fig. 17 is a circuit diagram of a wideband 90 degrees phase shifter realized as an analog circuit and the phase property thereof according to the embodiment of the present invention;
Fig. 18 is a diagram showing the FM signal demodulating method realized by an analog circuit according to the embodiment of the present invention; and
Fig. 19 is a diagram showing the property between the frequency shift and the output of a ratio detecting circuit according to the embodiment of the present invention.

Hereinbelow, a specific description of an embodiment according to the present invention is given.

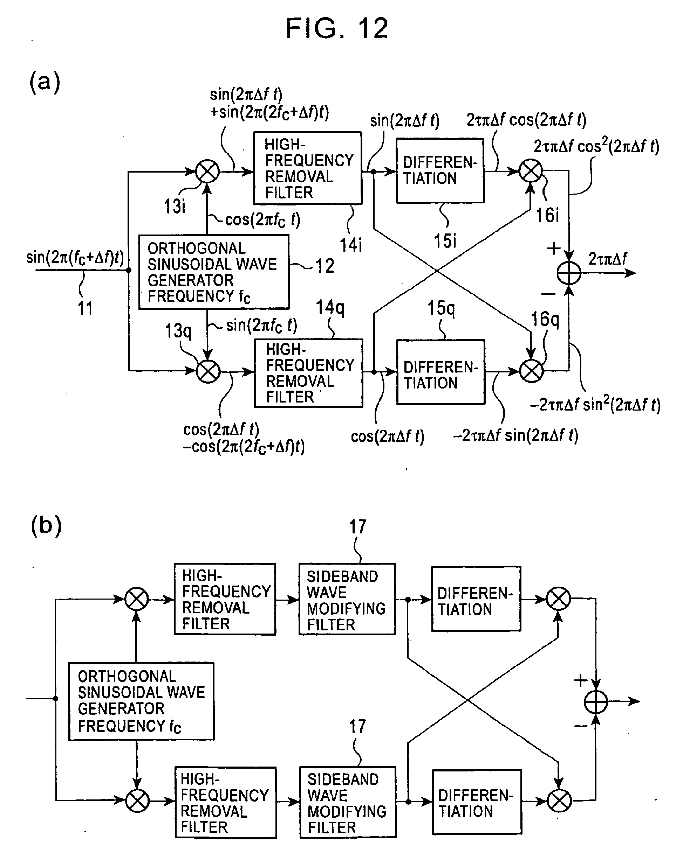

Fig. 12 is a diagram showing an FM signal demodulating method. Referring to Fig. 12, reference symbol $f_c$ denotes a nominal central frequency of an FM signal, reference symbol $\Delta f$ denotes frequency shift of the FM signal, reference symbol $\tau$ denotes a time constant for differentiation, reference symbols I and Q denote intermediate-frequency signals around 0 Hz having phases different from each other by 90 degrees generated by downconverting FM signal frequencies, and reference symbols dI and dQ denote signals obtained by differentiating the I and Q.
Referring to Fig. 12, an orthogonal sinusoidal wave generator 12 generates sinewave signals having phases different from each other by 90 degrees. The frequency value of these sinewave signals is equal to the central frequency fc of an FM signal. The sinusoidal wave signals and the FM signal 11 are inputted to a pair of mixers 13i and 13q and frequency-converted to signals with center frequency of 0 hz, and high-frequency components of the converted signals are removed by high-frequency removing filters 14i and 14q, thereby obtaining intermediate-frequency signals I and Q. The frequencies of the intermediate-frequency signals I and Q are equal to the frequency shift $\Delta f$ of the original FM signal 11, and the phases thereof are different from each other by 90 degrees. For a brief description, it is assumed that the amplitudes of the signals I and Q are 1. Then, the following relationship is established.

$$I=\sin (2\pi\Delta ft), \quad Q=\cos(2\pi\Delta ft)$$

Subsequently, the signals I and Q are time-differentiated by differentiators 15i and 15q, thereby obtaining the signals dI and dQ. The amplitudes of the signals dI and dQ are proportional to the frequency shift Δf, the frequencies of the signals dI and dQ are equal to each other, and the phases of the signals dI and dQ are equal to those of the intermediate-frequency signals Q and I. That is,

$$dI=2\tau\pi\Delta f\cos(2\pi\Delta ft),$$

and

$$dQ=-2\tau\pi\Delta f\sin(2\pi\Delta ft),$$

where τ: time constant for differentiation.

Next, one of the outputs Q•dI and I•dQ of the pair of multipliers 16i and 16q are subtracted from the other. Thus, a trigonometric function is erased by Pythagorean theorem and 2τπΔf thus remains. Consequently, 2τπΔf is outputted. That is, the following relationship is established.

$$Q \cdot dI - I \cdot dQ = 2\tau\pi\Delta f\cos^2(2\pi\Delta ft) + 2\tau\pi\Delta f\sin^2(2\pi\Delta ft) = 2\tau\pi\Delta f$$

As shown in Fig. 12(b), the band limit of the sideband waves is realized by filtering the signal I and the signal Q by a sideband wave modifying filter 17.

The entire FM signal demodulating method can be realized by an analog circuit. Alternatively, units up to the high-frequency removing filter 14i and 14q can be realized by analog circuits, the intermediate-frequency signals I and Q can be A/D-converted, and the subsequent processing can be realized by digital signal processing.

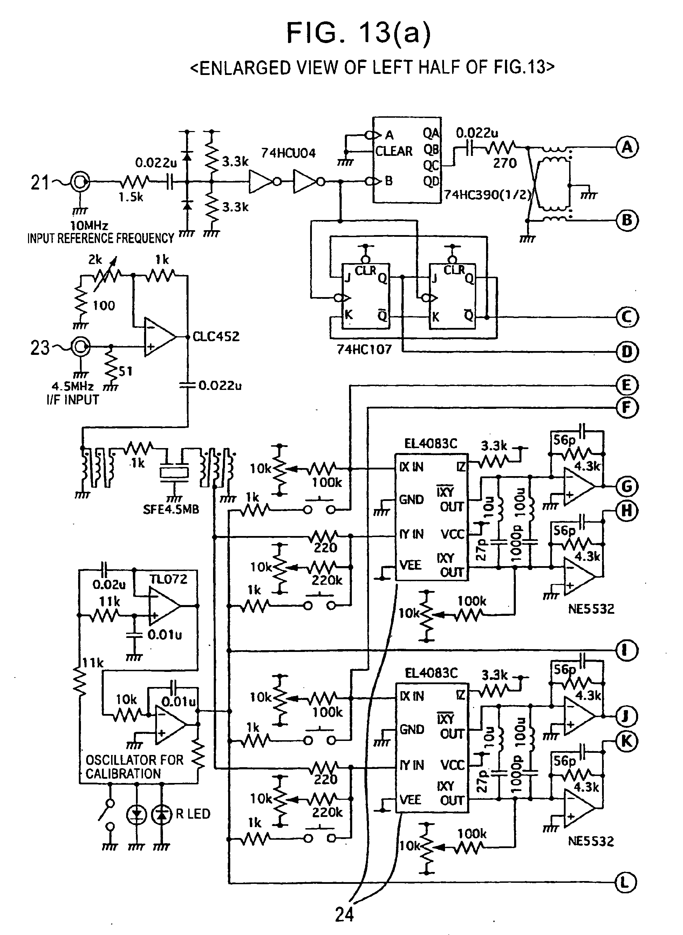

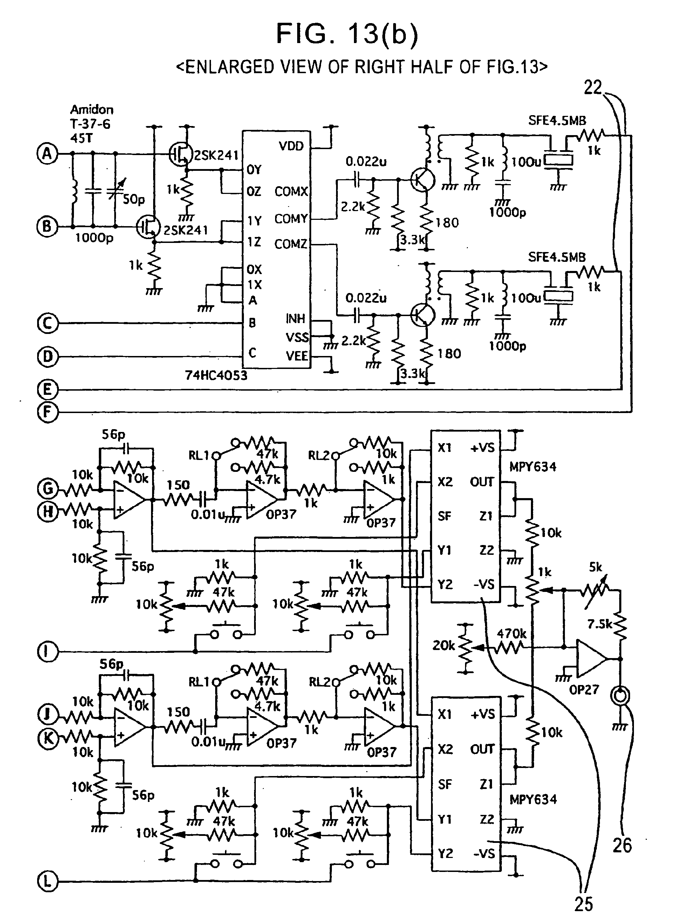

Fig. 13 is a diagram showing the FM signal demodulating method which is realized by the analog circuits.

The central frequency is designed to 4.5 MHz.

Referring to Fig. 13, orthogonal sinusoidal waves 22 of 4.5 MHz are generated from a reference signal 21 of 10 MHz. The orthogonal sinusoidal waves 22 and an FM signal 23 are inputted to a pair of mixers 24. Then, the signal I and the signal Q are generated. The signal I and the signal Q are differentiated by differentiators using operational amplifiers, and the resultant signals are inputted to multipliers 25. The outputs from the multipliers 25 are subtracted from each other, thereby obtaining an output 26.

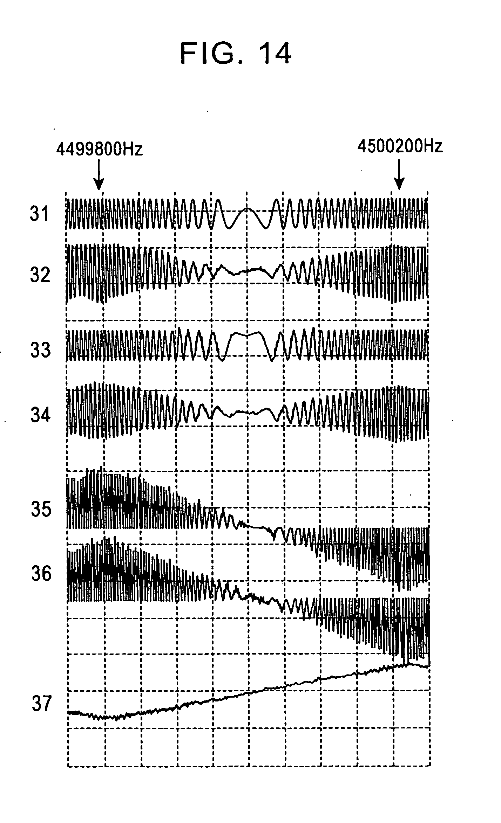

Fig. 14 shows waveforms in the circuit, upon inputting the FM signal whose frequency linearly changes from 4,499,800 Hz to 4,500,200 Hz to the FM signal demodulator according to the embodiment.

As mentioned above, the central frequency of the demodulator is 4,500,000 Hz. Therefore, the above-mentioned frequency shift of the FM signal ranges from -200 Hz to +200 Hz. Reference numerals 31 and 33 denote the signal I and signal Q. It is not determined, by one of the signals I and Q, whether the frequency shift is positive or negative. However, after/before the frequency is 0 in the center of graph, the phase difference between the signal I and the signal Q is inverted, thereby expressing the positive or negative of the frequency shift. Reference numerals 32 and 34 denote the signal dI and the signal dQ whose amplitudes are changed in proportional to the frequency by the differentiation. Reference numerals 35 and 36 denote I•dQ and Q•dI. Since the sign of one of 35 and 36 is inverted, I•dQ and Q•dI are added by an inverting adding circuit, thereby obtaining an output 37.

With the above-mentioned structure, the following problems are solved.

(1) Since the sensitivity of the FM signal demodulator is determined by only the time constant of differentiation, the change in response speed due to the change of sensitivity is prevented.
(2) The sensitivity can be easily changed by changing the time constant of differentiation.
(3) Since the differentiation has no group delay, the FM signal demodulator according to the present invention does not have any components for limiting the response speed on the principle and the waveform distortion is not caused in principle.
(4) The central frequency of the FM signal demodulator is determined depending on the frequency of the orthogonal sinusoidal wave generator. Therefore, an oscillator with accuracy corresponding to a purpose can be used. For example, a signal generated based on an atomic clock can be used as the 10 MHz reference signal. Then, the central frequency can be stabilized to $10^{-5}$ Hz.

(5) Since the differentiation has a linear property between the frequency and the amplitude, the FM signal demodulating method has a linear relationship between the frequency and the output value.
(6) According to the FM signal demodulating method instability due to the feedback loop is not caused.

Further, as an advantage, when the amplitude and the phase of the orthogonal sinusoidal wave generator include rather large errors, this does not influence on the performance for demodulating the FM signal. That is, when the amplitudes of two sinewave signals outputted by the orthogonal sinusoidal wave generator 12 are different, I•dQ and Q•dI have the same amplitude. Therefore, the demodulating result does not include the vibrating component. When the phase difference between the two sinewave signals outputted by the orthogonal sinusoidal wave generator 12 is not precisely 90 degrees, the component of precise 90 degrees includes the same-phase component. Since the multiplying results of the multipliers 16i and 16q due to the same-phase component have the same formula, the component is finally subtracted and is erased.

In the case of using the FM signal demodulating device for an atomic force microscopy, in general, the frequency shift of a cantilever sensor from its central frequency is around 1 Hz and the repetition rate of the shift is about 1 kHz, and one-time measurement takes several tens of minutes. The central frequency needs to be stable during the measurement. When the dimension of the cantilever is very small, frequency shift can be as small as 100 Hz while the repetition rate is as high as 100 kHz.

The sensitivity is easily changed as mentioned above, the response speed is fast, and the stability of the central frequency is high. The above-mentioned flexible request can be satisfied.

In order to limit the band of the sideband waves, the conventional demodulating method as mentioned above needs the band pass filter. On the other hand, according to the FM signal demodulating method shown in [Figs. 15(a) and 15(c)], the frequency is converted into a frequency around 0 Hz, therefore, the sideband waves exist symmetrically with 0 Hz as shown in [Fig. 15(c)], a low-pass filter as shown in [Fig. 15(d)], serving as the sideband wave modifying filter 17, is used, thereby automatically exhibiting a filter symmetrical to the upper and lower sideband waves. Since the low pass filter is a filter for low frequency, a filter with high precision is provided, as an active filter or a digital filter, and the property can easily be changed.

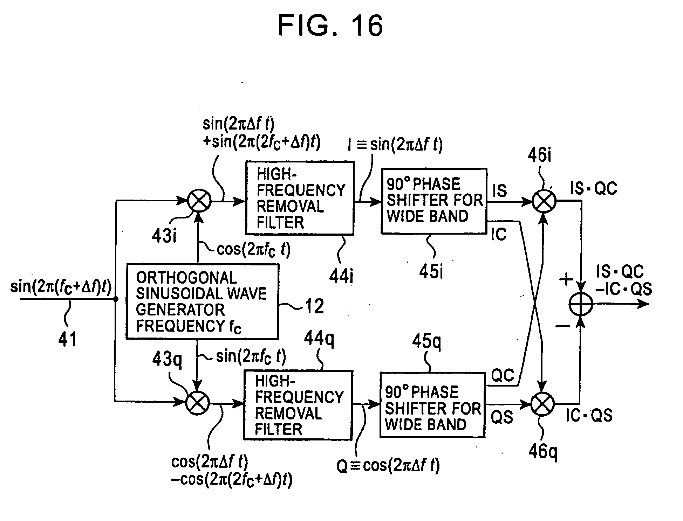

Fig. 16 is a block diagram showing an FM signal demodulating method according to an embodiment of the present invention.

Referring to Fig. 16, an orthogonal sinusoidal wave generator 42 generates sinusoidal waves having phases different from each other by 90 degrees. The frequency value of these sinewave signals is equal to the central frequency fc of an FM signal. The sinusoidal wave signals and the FM signal 11 are inputted to a pair of mixers 43i and 43q and frequency-converted to signals with center frequency of 0 Hz, and high-frequency components of the signals are removed by high-frequency removing filter 44i and 44q, thereby obtaining the signals I and Q. Frequencies of the signals I and Q are equal to the frequency shift $\Delta f$ of the original FM signal 41, and phases of the signals I and Q are different from each other by 90 degrees. For a brief description, it is assumed that the amplitudes of the signals I and Q are 1. Then, relationships of $I=\sin(2\pi\Delta ft)$ and $Q=\cos(2\pi\Delta ft)$ are obtained.

The signals I and Q are inputted to wideband 90 degrees phase shifters 45i and 45q having the same property. The wideband 90 degrees phase shifters 45i and 45q output two signals, respectively. The wideband 90 degrees phase shifters 45i and 45q output signals IS, IC, QS, and QC. Then, according to the FM signal demodulating method of embodiments of the present invention, calculation of IS•QC-IC•QS between the signals IS, IC, QS, and QC is outputted.

Here, the wideband 90 degrees phase shifters 45i and 45q approximately realize Hilbert transform. In the Hilbert transform, if the frequency of the input signal is positive, the phase shift of +90 degrees is applied and, if the frequency of the input signal is negative, the phase shift of -90 degrees is applied. Reference numerals 46i and 46q denote multipliers.

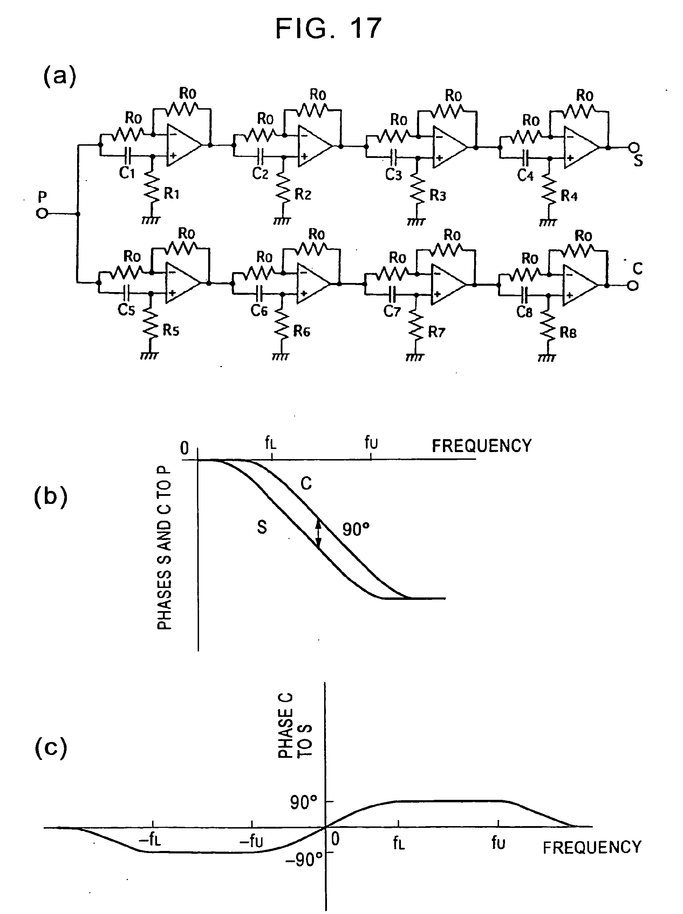

Fig. 17 is a diagram showing one example of the wideband 90 degrees phase shifter comprising an analog circuit, Fig. 17(a) is a circuit diagram of the analog circuit, Fig. 17(b) is a diagram showing the phase property, and Fig. 17(c) is a diagram showing a relationship between the phase difference and the frequency between outputs S and C.

The circuit is formed by connecting a first-degree allpass filter by many stages, the amplitude gain is always 1, and only the phase is changed. It is known that by using appropriate values to time constants $C_1•R_1$ to $C_8•R_8$, the circuit serves as an approximated Hilbert transformer (Non-Patent Document 2 mentioned above). Actually unlike the true Hilbert transform, the frequency for realizing the phase shift by 90 degrees has the lower limit and the upper limit, and the phase difference between the two outputs is approximated to 90 degrees within a predetermined error range at the frequency between the lower limit and the upper limit, in place of fixing the phase difference between the input and the output to 90 degrees.

As shown in Fig. 17(b), the phase difference between an input P and the output S and the phase difference between the input P and the output C linearly increase between a lower-limit frequency $f_L$ and an upper-limit frequency $f_U$. Upon paying attention to the phase difference between the output S and the output C, 90 degrees are kept between the lower-limit frequency $f_L$ and the upper-limit frequency $f_U$.

Referring to Fig. 17(c), although the frequency is extended to the negative one, a graph of the positive frequency is symmetrically to the origin.

According to the FM signal demodulating method of embodiments of the present invention using the wideband 90 degrees phase shifter having the above-mentioned property, when the frequency shift $\Delta f$ of the FM signal is positive between the lower-limit frequency $f_L$ and the upper-limit frequency $f_U$ of the wideband 90 degrees phase shifter ($f_L < \Delta f < f_U$), output signals IS, IC, QS, and QC from wideband phase shifters are as follows.

$$IS = \sin(2\pi\Delta ft + \theta)$$

$$IC = \sin(2\pi\Delta ft + \theta + \pi) = \cos(2\pi\Delta ft + \theta)$$

$$QS = \cos(2\pi\Delta ft + \theta)$$

$$QC = \cos(2\pi\Delta ft + \theta + \pi) = -\sin(2\pi\Delta ft\theta)$$

Incidentally, reference numeral $\theta$ denotes the phase shift depending on the frequency shift $\Delta f$. [0072]

In this case, the output of the FM signal demodulating method is as follows.

$$IS \cdot QC - IC \cdot QS$$
$$= -\sin^2 \cdot (2\pi\Delta ft + \theta) - \cos^2(2\pi\Delta ft + \theta)$$
$$= -1$$

That is, -1 is outputted, irrespective of the frequency shift $\Delta f$. On the other hand, when the frequency shift $\Delta f$ of the FM signal is negative between the lower-limit frequency $f_L$ and the upper-limit frequency $f_U$ of the wideband 90 degrees phase shifter ($-f_U < \Delta f < -f_L$), a relationship of IS·QC-IC·QS=1 is obtained. That is, +1 is outputted, irrespective of the frequency shift $\Delta f$.

When the frequency shift $\Delta f$ of the FM signal is between the positive and negative lower-limit frequencies $f_L$ ($-f_L < \Delta f < f_L$), the output smoothly changes from +1 to -1. When the frequency shift $\Delta f$ is zero, the output is zero. That is, in the area, the frequency shift $\Delta f$ is proportional to the output. The area is used as the FM signal demodulator.

The FM signal demodulating method of embodiments of the present invention can be entirely realized by an analog circuit. Alternatively, the units up to the high-frequency removing filter 44i and 44q can be realized by analog circuits, the intermediate-frequency signals I and Q can be A/D converted, and the subsequent processing can be realized by digital signal processing.

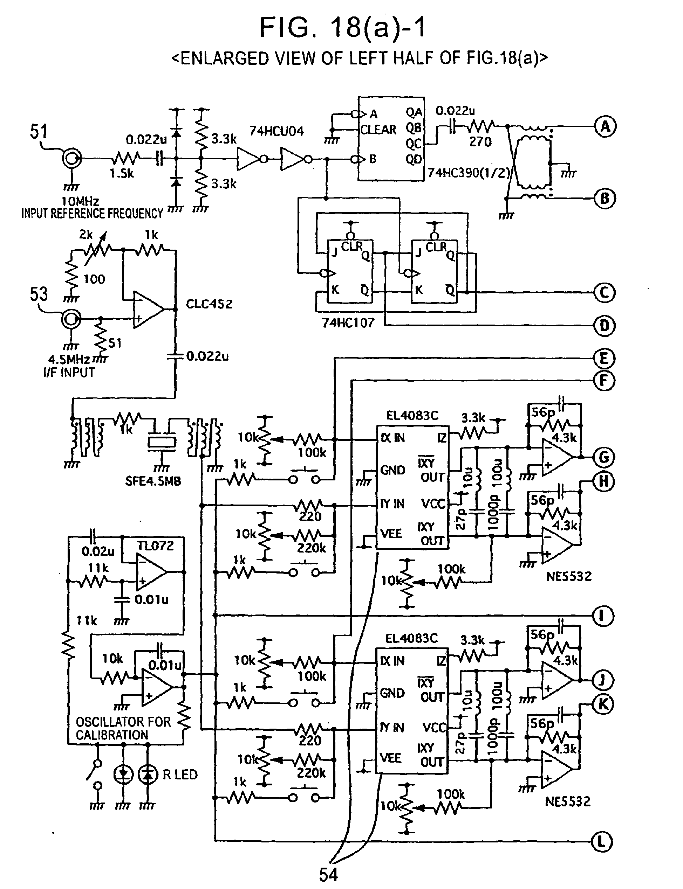

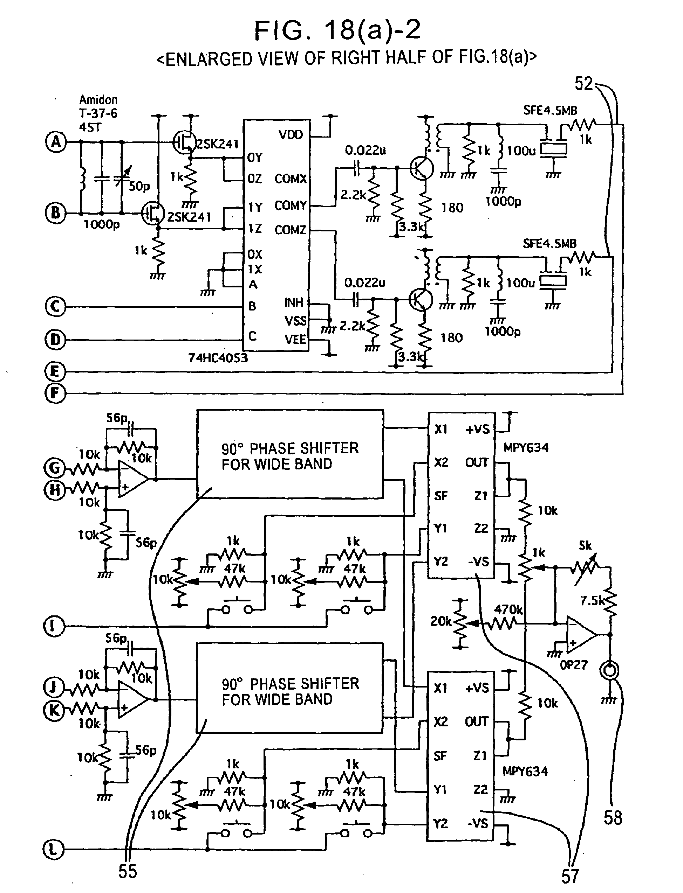

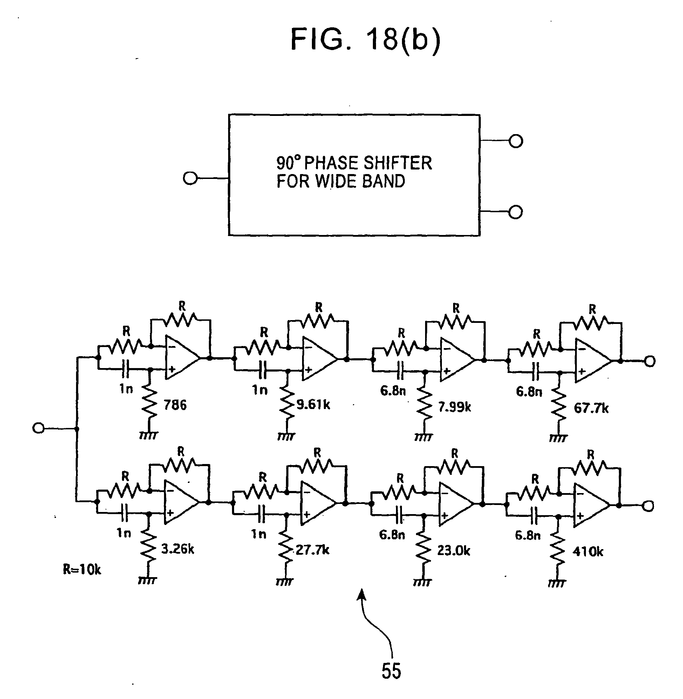

Fig. 18 is a diagram showing the FM signal demodulating method realized by an analog circuit according to the embodiment of the present invention, Fig. 18(a) is a diagram showing the entire circuit, and Fig. 18(b) is a circuit diagram showing the wideband 90 degrees phase shifter.

Here, the central frequency is designed to 4.5 MHz. Orthogonal sinusoidal waves 52 of 4.5 MHz are generated from a reference signal 51 of 10 MHz. The sinusoidal waves and an FM signal 53 are inputted to a pair of mixers 54, and the intermediate-frequency signals I and Q are generated. The signals I and Q are inputted to wideband 90 degrees phase shifters 55. The total four outputs of the wideband 90 degrees phase shifter 55 are inputted to two multipliers 57, and the outputs are mutually subtracted (actually, inverse addition because one sign of the two outputs is inverted before the multiplier 57), thereby obtaining an output 58.

Fig. 18(b) specifically shows the wideband 90 degrees phase shifter 55. The lower-limit frequency $f_L$ is 100 Hz, the upper-limit frequency $f_U$ is 100 kHz, and the phase error is approximately 2 degrees.

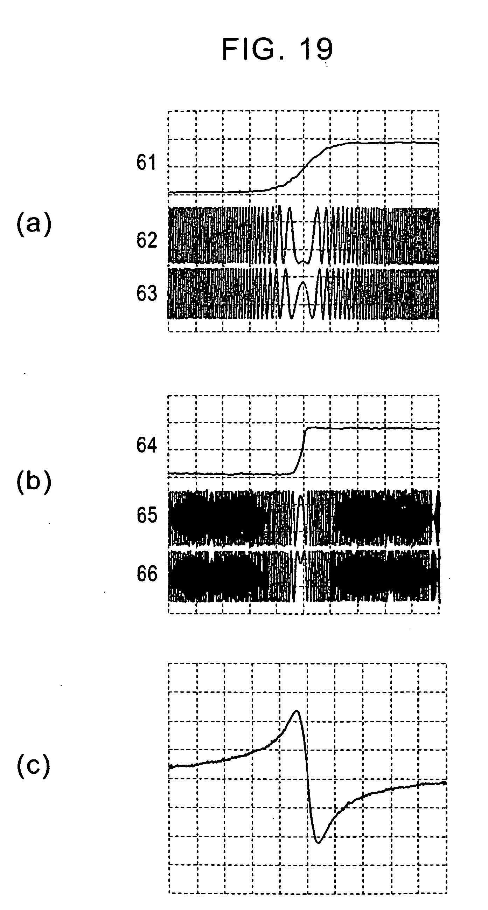

Fig. 19 is a diagram showing the property between the output and the frequency shift of a ratio detecting circuit according to the embodiment of the present invention.

Fig. 19(a) shows an output 61, an I signal 62, and a Q signal 63, upon sweeping the frequency of the FM signal 53 from 4,499,800 Hz to 4,500,200 Hz (frequency shift of $\pm$200 Hz) according to the embodiment.

Similarly, Fig. 19(b) shows an output 64, an I signal 65, and a Q signal 66, upon sweeping the frequency of the FM signal 53 from 4,499,000 Hz to 4,501,000 Hz (frequency shift of $\pm$1 kHz).

As is obvious from the actually measured waveforms Figs. 19(a) and 19(b) showing the relationship between frequency shift and output according to the embodiment, the relationship between the frequency and the output value is proportional near the center at which the frequency shift is small; it means that the embodiment operated as an FM signal demodulator within this range. Further, when the frequency shift is over the range, the output smoothly saturated. According to the embodiment, the output is not reduced within the range of the frequency shift of $\pm$100 kHz.

For comparison with the conventional technology, Fig. 19(c) shows an example of the property between the output and the frequency shift in the ratio detecting circuit. The ratio detecting circuit is designed so that 9 MHz is in center. Fig. 19(c) shows the change in output value upon sweeping an input frequency from 8 to 10 MHz.

Obviously with reference to Fig. 19(c), when the frequency is out of the range in which the output is proportional to frequency shift, the output value of the ratio detecting circuit is promptly reduced.

The present invention is not limited to the embodiment, can be variously modified within the essentials according to the present invention, and the modification can be included in the range according to the present invention.

As mentioned in detail above, embodiments of the present invention have the following advantages.

(A) Since the sensitivity of the FM signal demodulator is determined by only the time constant for differentiation, the change in response speed due to the change of sensitivity is prevented.

(B) The sensitivity can be easily changed by changing the time constant for differentiation.

(C) Since the differentiation has no group delay, the FM signal demodulator according to embodiments of the present invention does not have any components for limiting the response speed on the principle and waveform distortion is not caused in principle.

(D) The central frequency of the FM signal demodulator according to embodiments of the present invention is determined depending on the frequency of the orthogonal sinusoidal wave generator. Therefore, an oscillator with accuracy corresponding to a purpose can be used. For example, a signal generated based on an atomic clock can be used as the 10 MHz reference signal according to the embodiment. Then, the central frequency can be stabilized to $10^{-5}$ Hz.

(E) Since the differentiation has a linear property between the frequency and the amplitude, the FM signal demodulating method according to embodiments of the present invention has a linear relationship between the frequency and the output value.

(F) According to the FM signal demodulating method of embodiments of the present invention, the instability due to feedback loop is not caused.

Further, the FM signal demodulating method has the property for smoothly saturating the output relative to the frequency shift which is excessively over the demodulating range as the target.

Industrial Applicability

Embodiments of the present invention provide an FM signal demodulating method and a device thereof can be used for scanning probe microscopy, digital signal processing and fields of information communication.

**Claims**

**1.** An FM signal demodulating device for detecting the shift of an oscillating frequency comprising:

a first mixer (43i) for mixing the input signal ($sin(2\pi(f_c+\Delta f)t)$) with a inphase LO *(cos($2\pi f_c t$))*;
a second mixer (43q) for mixing the input signal *($sin(2\pi(f_c+\Delta f)t)$)* with quadrature phase LO *($sin(2\pi f_c t$))*;
a first low pass filter (44i) receiving the first mixer (43i) output;
a second low pass filter (44q) receiving the second mixer (43q) output;
**characterised in that** the device further comprises:

a first wideband 90 degree phase shifter (45i) receiving the first low pass filter (44i) output ($I{\equiv}sin(2\pi\Delta ft)$), the first wideband 90 degree phase shifter (45i) being configured to provide a first output signal IS and a second output signal IC, the phase difference between the signal IS and the signal IC being substantially 90 degrees within the operation frequency band of the first wideband 90 degree phase shifter (45i);

a second wideband 90 degree phase shifter (45q) receiving the second low pass filter (44q) output ($Q \equiv cos(2\pi\Delta ft)$), the second wideband 90 degree phase shifter (45q) being configured to provide a first output signal QS, and a second output signal QC, the phase difference between the signal QS and the signal QC being substantially 90 degrees within the operation frequency band of the second wideband 90 degree phase shifter (45q);

a first multiplier (46i) receiving the signal IS from the first wideband 90 degree phase shifter (45i) and the signal QC from the second wideband 90 degree phase shifter (45q);

a second multiplier (46q) receiving the signal IC from the first wideband 90 degree phase shifter (45i) and the signal QS from the second wideband 90 degree phase shifter (45q); and

a summer summing outputs (IS•QC and IC•QS) of multipliers (46i,46q).

## Patentansprüche

1. Vorrichtung zur Demodulierung von UKW-Signalen zum Erkennen der Verschiebung einer oszillierenden Frequenz, umfassend:

   einen ersten Mischer (43i) zum Mischen des Eingangssignals ($sin(2\pi(f_c+\Delta f)t)$) mit einem Inphase-Lokaloszillator LO ($cos(2\pi f_c t)$);

   einen zweiten Mischer (43q) zum Mischen des Eingangssignals ($sin(2\pi(f_c+\Delta f)t)$) mit einem Quadraturphase-LO ($sin(2\pi f_c t)$);

   ein erster Tiefpassfilter (44i), das das Ausgangssignal des ersten Mischers (43i) empfängt;

   ein zweiter Tiefpassfilter (44q), das das Ausgangssignal des zweiten Mischers (43q) empfängt;

   **dadurch gekennzeichnet, dass** die Vorrichtung ferner Folgendes umfasst:

   einen ersten 90-Grad-Breitbandphasenschieber (45i), der das Ausgangssignal des ersten Tiefpassfilters (44i) ($I \equiv sin(2\pi\Delta ft)$) empfängt, wobei der erste 90-Grad-Breitbandphasenschieber (45i) dafür konfiguriert ist, ein erstes Ausgangssignal IS und ein zweites Ausgangssignal IC bereitzustellen, wobei die Phasendifferenz zwischen dem Signal IS und dem Signal IC im Wesentlichen 90 Grad innerhalb des Betriebsfrequenzbandes des ersten 90-Grad-Breitbandphasenschiebers (45i) beträgt;

   einen zweiten 90-Grad-Breitbandphasenschieber (45q), der das Ausgangssignal des zweiten Tiefpassfilters (44q) ($Q \equiv cos(2\pi\Delta ft)$) empfängt, wobei der zweite 90-Grad-Breitbandphasenschieber (45q) dafür konfiguriert ist, ein erstes Ausgangssignal QS und ein zweites Ausgangssignal QC bereitzustellen, wobei die Phasendifferenz zwischen dem Signal QS und dem Signal QC im Wesentlichen 90 Grad innerhalb des Betriebsfrequenzbandes des zweiten 90-Grad-Breitbandphasenschiebers (45q) beträgt;

   einen ersten Multiplizierer (46i), der das Signal IS von dem ersten 90-Grad-Breitbandphasenschieber (45i) und das Signal QC von dem zweiten 90-Grad-Breitbandphasenschieber (45q) empfängt;

   einen zweiten Multiplizierer (46q), der das Signal IC von dem ersten 90-Grad-Breitbandphasenschieber (45i) und das Signal QS von dem zweiten 90-Grad-Breitbandphasenschieber (45q) empfängt; und

   einen Summierer, der die Ausgangssignale (IS•QC und IC•QS) der Multiplizierer (46i, 46q) addiert.

## Revendications

1. Dispositif de démodulation de signaux FM permettant de détecter le déplacement d'une fréquence d'oscillation comprenant :

   un premier mélangeur (43i) permettant de mélanger le signal d'entrée ($sin(2\pi(f_c+\Delta f)t)$) à un signal LO en phase ($cos(2\pi f_c t)$);

   un deuxième mélangeur (43q) permettant de mélanger le signal d'entrée ($sin(2\pi(f_c+\Delta f)t)$) à un signal LO en phase quadrivalente ($sin(2\pi f_c t)$);

   un premier filtre passe-bas (44i) recevant le signal de sortie du premier mélangeur (43i) ;

   un deuxième filtre passe-bas (44q) recevant le signal de sortie du deuxième mélangeur (43q) ;

   **caractérisé en ce que** le dispositif comprend en outre :

   un premier déphaseur à 90 degrés à large bande (45i) recevant le signal de sortie ($I \equiv sin(2\pi\Delta ft)$) du premier filtre passe-bas (44i), le premier déphaseur à 90 degrés à large bande (45i) étant configuré de manière à générer un premier signal de sortie IS et un deuxième signal de sortie IC, la différence de phase entre le signal IS et le signal IC étant essentiellement de 90 degrés dans la bande de fréquences d'exploitation du premier déphaseur à 90 degrés à large bande (45i) ;

un deuxième déphaseur à 90 degrés à large bande (45q) recevant le signal de sortie (QΞ$cos(2\pi\Delta ft)$) du deuxième filtre passe-bas (44q), le deuxième déphaseur à 90 degrés à large bande (45q) étant configuré de manière à générer un premier signal de sortie QS et un deuxième signal de sortie QC, la différence de phase entre le signal QS et le signal QC étant essentiellement de 90 degrés dans la bande de fréquences d'exploitation du deuxième déphaseur à 90 degrés à large bande (45q) ;

un premier multiplicateur (46i) recevant le signal IS provenant du premier déphaseur à 90 degrés à large bande (45i) et le signal QC provenant du deuxième déphaseur à 90 degrés à large bande (45q) ;

un deuxième multiplicateur (46q) recevant le signal IC provenant du premier déphaseur à 90 degrés à large bande (45i) et le signal QS provenant du deuxième déphaseur à 90 degrés à large bande (45q) ; et

un sommateur faisant la somme des signaux de sortie (IS•QC et IC•QS) des multiplicateurs (46i, 46q).

# FIG. 1

# FIG. 2

# FIG. 3

71

76
PHASE
COMPARATOR

77

FILTER

RESONANT
CIRCUIT

73

74

72

75

# FIG. 4

8C   8A   8B

FREQUENCY

0°

PHASE

−90°

−180°

# FIG. 5

(a)

PHASE
COMPARATOR

FILTER

(b)

PHASE
COMPARATOR

FILTER

(c)

PHASE
COMPARATOR

FILTER

# FIG. 6

# FIG. 7

(a)

(b)

119

# FIG. 8

# FIG. 9

(a)

$$f = f_0$$
$$|V_3 - V_2/2| = |V_3 + V_2/2|$$

(b)

$$f > f_0$$
$$|V_3 - V_2/2| > |V_3 + V_2/2|$$

(c)

f: INPUT FREQUENCY

fo: RESONANT FREQUENCY
DECIDED BY $L_2$ AND $C_2$

$$f < f_0$$
$$|V_3 - V_2/2| < |V_3 + V_2/2|$$

# FIG. 10

# FIG. 11

(a)

DETECTING OUTPUT VOLTAGE

FREQUENCY

(b)

DETECTING OUTPUT VOLTAGE

FREQUENCY

(c)

DETECTING OUTPUT VOLTAGE

FREQUENCY

# FIG. 12

(a)

(b)

# FIG. 13(a)

<ENLARGED VIEW OF LEFT HALF OF FIG.13>

# FIG. 13(b)

### <ENLARGED VIEW OF RIGHT HALF OF FIG.13>

# FIG. 14

# FIG. 15

(a)

SPECTRUM STRENGTH

0                                    FREQUENCY

(b)

AMPLITUDE GAIN

0                                    FREQUENCY

(c)

SPECTRUM STRENGTH

0                                    FREQUENCY

(d)

AMPLITUDE GAIN

0                                    FREQUENCY

# FIG. 16

# FIG. 17

(a)

(b)

(c)

# FIG. 18(a)-1

<ENLARGED VIEW OF LEFT HALF OF FIG.18(a)>

54

# FIG. 18(a)-2

<ENLARGED VIEW OF RIGHT HALF OF FIG.18(a)>

# FIG. 18(b)

# FIG. 19

(a)

61

62

63

(b)

64

65

66

(c)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- Information Communication and Digital Signal Processing (Joho Tsushin to digital signal shori. **TAKASHI TANIHAGI.** Digital-Signal-Processing Library 8. CORONA, 153-154

- **S. D. BEDROSIAN.** IRE Transactions on Circuit Theory. *Normalized Design of 90 degrees Phase-Difference Networks,* June 1960, 128-136
- High Speed Direct Conversion FM demodulator. *IBM Technical Disclosure Bulletin,* 01 September 1920, vol. 35 (4B), 344-345